# FASCICULE DE BREVET EUROPEEN

(11) **EP 3 448 802 B1**
(45) Date de publication et mention de la délivrance du brevet: **22.04.2020**
(21) Numéro de dépôt: 16720804.0
(22) Date de dépôt: 29.04.2016
(51) Int. Cl.: B81B 3/00

(54) **COMPOSANT ÉLECTROMÉCANIQUE ET SON PROCÉDÉ DE FABRICATION**
ELEKTROMECHANISCHE KOMPONENTE UND HERSTELLUNGSVERFAHREN DAFÜR
ELECTROMECHANICAL COMPONENT AND PRODUCTION METHOD THEREOF

(43) Date de publication de la demande: 06.03.2019
(73) Titulaire: Sigatec SA, 1950 Sion (CH)
(72) Inventeur: GLASSEY, Marc-André, 1967 Bramois (CH)
(74) Mandataire: BOVARD AG
(86) Numéro de dépôt international: PCT/EP2016/059602
(87) Numéro de publication internationale: WO 2016/177636

(56) Documents cités:
- US-A1- 2002 054 466

## Description

### Domaine technique de l'invention

La présente invention concerne un composant électromécanique et elle trouve application notamment dans le domaine des microsystèmes électromécaniques encore appelés MEMS (acronyme de la dénomination anglaise « Microelectromechanical systems »).

En particulier, la présente invention peut être mise en oeuvre dans un actionneur électromécanique, qui est un dispositif à même de produire un travail à partir d'énergie électrique, c'est-à-dire de générer un mouvement lorsqu'il est connecté à une source d'énergie électrique. La présente invention peut également être mise en oeuvre dans un générateur électrique. Selon un fonctionnement inverse de celle d'un actionneur électromécanique, un générateur électrique transforme de l'énergie mécanique en énergie électrique. En d'autres termes, il transforme un mouvement en courant électrique.

L'invention peut également être incorporée dans un dispositif de production d'une fréquence d'oscillation stable pouvant servir de base de temps pour le fonctionnement d'un microprocesseur ou d'une montre. En effet, un composant électronique actif peut être employé pour faire alterner les modes actionneur et générateur du composant électromécanique selon l'invention et faire ainsi fonctionner ce composant électromécanique en oscillateur.

Une autre application concrète de la présente invention est la détection et la mesure. En effet, l'invention peut être mise en œuvre dans un capteur.

D'autres applications pratiques et utiles du composant électromécanique selon l'invention sont aussi possibles.

### État de la technique

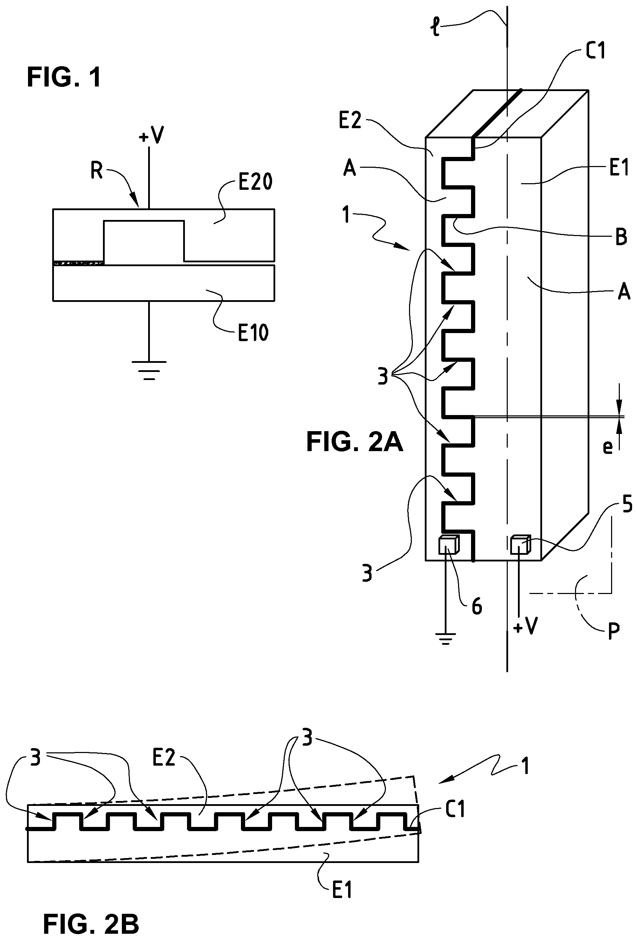

La figure 1 est un schéma de principe d'un premier type d'actionneur électrostatique conventionnel, qui est dit à « plans parallèles ». Dans ce premier type d'actionneur électrostatique, deux électrodes planes E10 et E20 sont disposées en regard l'une de l'autre. L'électrode E10 est fixe, tandis que l'électrode E20 est mobile et rappelée par une partie formant ressort R. Lorsqu'une tension est appliquée entre les deux électrodes E10 et E20, l'électrode mobile E20 se rapproche de l'électrode fixe E10. Lorsqu'on stoppe l'application de la tension, l'électrode mobile E20 est remise dans sa position initiale par la partie formant ressort R. EP2664058 B1 décrit un actionneur électrostatique comportant une portion élastiquement flexible qui peut être cintrée. Ce composant électromécanique peut également servir de capteur de flexion.

La configuration à « plans parallèles » dont un exemple est représenté à la figure 1 est également celle de certains accéléromètres. Lorsque tel est le cas, une accélération appliquée à l'accéléromètre provoque un déplacement relatif d'une masse, ce déplacement faisant varier la distance et donc la capacité entre les électrodes E10 et E11. Cette capacité est mesurée et constitue l'organe de détection de l'accélération.

Dans un deuxième type d'actionneur électrostatique connu (généralement appelé par sa désignation anglaise « comb drive »), les électrodes forment deux peignes qui s'interpénètrent. Cette disposition permet une optimisation de la capacité entre les électrodes et une flexibilité plus importante. Le deuxième type d'actionneur électrostatique possède le même principe de fonctionnement que le premier type d'actionneur mentionné ci-dessus. En effet, un peigne est fixe, tandis que l'autre est mobile. Si les deux peignes restent parallèles l'un par rapport à l'autre, les forces d'attraction latérales s'annulent mutuellement et les électrodes effectuent un déplacement linéaire.

Il existe également des actuateurs/générateurs électrostatiques capables de générer ou d'utiliser un déplacement rotatif.

Dans tous les actuateurs/générateurs électrostatiques conventionnels mentionnés ci-dessus, l'électrode mobile doit être tenue et guidée, en plus de quoi elle doit être rappelée vers une position de repos par un ressort additionnel.

### Exposé sommaire de l'invention

L'invention a au moins pour but de proposer un composant électromécanique qui constitue une alternative aux composants électromécaniques actuellement connus.

Selon l'invention, ce but est atteint grâce à un composant électromécanique, par exemple utilisable au moins comme actionneur, comme capteur capacitif, comme oscillateur ou comme générateur. Ce composant électromécanique comprend au moins une première électrode, une deuxième électrode, ainsi qu'une couche diélectrique liant mécaniquement la première et la deuxième électrode l'une à l'autre et isolant électriquement la première et la deuxième électrode l'une de l'autre. Le composant électromécanique a une capacité fonction d'une épaisseur constante ou non de la couche diélectrique et comporte une portion élastiquement flexible où sont présentes la première électrode, la deuxième électrode et la couche diélectrique. Au niveau de la portion élastiquement flexible, la couche diélectrique comporte plusieurs tronçons particuliers ayant chacun une orientation et une position telles que, lorsque la portion élastiquement flexible est cintrée élastiquement, l'épaisseur de la couche diélectrique est modifiée au moins au niveau de ces tronçons particuliers de manière que la capacité du composant électromécanique soit changée.

Dans le composant défini ci-dessus, la première et la deuxième électrode sont liées mécaniquement entre elles et il n'y a pas d'électrode mobile qui doit être tenue et rappelée par une structure rendant l'ensemble coûteux et complexe. Le composant défini ci-dessus peut donc être simple et peu coûteux. Il peut en outre être robuste. Le composant défini ci-dessus peut en outre être de très petite taille. On peut en outre obtenir une très grande précision sur ses caractéristiques électriques, en particulier sur la capacité entre ses première et deuxième électrodes. De plus, le composant défini ci-dessus peut être très compact.

Le composant électromécanique selon l'invention a été imaginé conjointement à deux procédés de fabrication permettant chacun de le réaliser. Ces procédés de fabrication sont exposés plus loin. Au moins l'un d'eux constitue un autre aspect de l'invention. En d'autres termes, le composant électromécanique selon l'invention est tel qu'il existe au moins un procédé permettant de le réaliser.

Le composant électromécanique ci-dessus peut incorporer une ou plusieurs autres caractéristiques avantageuses, isolément ou en combinaison, en particulier parmi celles précisées ci-après.

Avantageusement, la portion élastiquement flexible est une portion qui est élastiquement flexible dans un plan de flexion et dont la section selon ce plan de flexion est une section allongée.

Avantageusement, la couche diélectrique s'étend selon une surface qui est cannelée sur au moins une partie de la longueur de la section allongée de la portion élastiquement flexible.

Avantageusement, la portion flexible est à même d'être cintrée dans le plan de flexion moyennant la présence de deux types de sollicitation, à savoir une compression et une traction dont chacune se produit dans l'une de deux régions distinctes de la portion élastiquement flexible, la surface cannelée selon laquelle s'étend la couche diélectrique ou la portion cannelée de la surface selon laquelle s'étend la couche diélectrique se trouvant plus dans l'une des deux régions distinctes que dans l'autre, par exemple entièrement dans l'une de ces deux régions distinctes.

Avantageusement, la couche diélectrique s'étend selon une ligne directrice et parallèlement à une génératrice. Avantageusement, cette génératrice est sensiblement perpendiculaire au plan de flexion.

Avantageusement, la première électrode est réalisée en un premier matériau qui est du silicium monocristallin, la couche diélectrique étant réalisée en un deuxième matériau, la deuxième électrode étant réalisée en un troisième matériau différent des premier et deuxième matériaux. Lorsque tel est le cas, il peut être obtenu une très grande précision sur l'épaisseur de la couche diélectrique. En particulier, cette très grande précision peut être obtenue avec le procédé de fabrication selon l'invention. Le silicium monocristallin de la première électrode est dopé ou fortement dopé afin d'être suffisamment conducteur.

Avantageusement, la première électrode est réalisée en silicium monocristallin, la couche diélectrique étant réalisée en oxyde de silicium. Avantageusement, la deuxième électrode est réalisée en silicium polycristallin. Le silicium polycristallin de la deuxième électrode est dopé ou fortement dopé afin d'être suffisamment conducteur. Lorsque la première électrode est réalisée en silicium monocristallin, que la couche diélectrique est réalisée en oxyde de silicium et que la deuxième électrode est réalisée en silicium polycristallin, il peut être obtenu une très grande précision sur l'épaisseur de la couche diélectrique. En particulier, cette très grande précision peut être obtenue avec le procédé de fabrication selon l'invention.

Avantageusement, chacun des tronçons particuliers a une orientation et une position telles que, lorsque la première et la deuxième électrode sont mises à des potentiels différents et produisent entre eux une compression de la couche diélectrique, la compression des tronçons particuliers amène la portion élastiquement flexible à se cintrer.

Avantageusement, le composant électromécanique comprend une borne de connexion à la première électrode, une borne de connexion à la deuxième électrode, ainsi qu'une masse d'inertie accouplée à la portion élastiquement flexible de manière à pouvoir cintrer élastiquement cette portion élastiquement flexible.

Avantageusement, la première électrode, la deuxième électrode, la couche diélectrique et la portion élastiquement flexible appartiennent à une première sous-partie du composant électromécanique. Avantageusement, ce composant électromécanique comprend au moins une deuxième sous-partie, cette deuxième sous-partie incluant les mêmes caractéristiques qu'un composant électromécanique tel que défini précédemment. Avantageusement, la portion élastiquement flexible de la première sous-partie et la portion élastiquement flexible de la deuxième sous-partie sont élastiquement flexibles dans un plan de flexion commun et/ou dans deux plans de flexion parallèles et sont accouplées l'une à l'autre au moyen d'un accouplement favorisant une synchronisation de leurs déformations élastiques respectives dans le plan de flexion commun et/ou de leurs déformations élastiques respectives dans les deux plans de flexion parallèles.

Avantageusement, ladite capacité est une première capacité. Avantageusement, le composant électromécanique comporte une structure à plans parallèles qui comprend deux électrodes, à savoir une troisième et une quatrième électrode. Avantageusement, le composant électromécanique a une deuxième capacité entre ces troisième et quatrième électrodes. Avantageusement, une extrémité de la portion élastiquement flexible porte la troisième électrode.

Avantageusement, les tronçons particuliers sont décalés entre eux le long de la section allongée de la portion élastiquement flexible.

Avantageusement, la section allongée s'étend selon une fibre moyenne.

Avantageusement, les tronçons particuliers sont non parallèles à la fibre moyenne.

Avantageusement, les tronçons particuliers sont excentrés par rapport à la fibre moyenne.

L'invention a également pour objet un procédé de fabrication d'un composant tel que défini précédemment. Ce procédé de fabrication comprend des étapes dans lesquelles :
a) on creuse au moins un trou dans une plaquette faite de silicium,
b) on crée la couche diélectrique au moins au niveau d'une paroi du trou,
c) on remplit le trou avec le matériau de la deuxième électrode,
d) dans la plaquette telle qu'elle a été modifiée par les étapes a) à c), on découpe le composant électromécanique.

Le procédé de fabrication défini ci-dessus peut incorporer une ou plusieurs autres caractéristiques avantageuses, isolément ou en combinaison, en particulier parmi celles précisées ci-après.

Avantageusement, la plaquette est faite de silicium monocristallin.

Avantageusement, on crée la couche diélectrique en oxyde de silicium, dans l'étape b).

Avantageusement, on crée la couche diélectrique en oxyde de silicium par oxydation thermique, dans l'étape b).

Avantageusement, le matériau avec lequel on remplit le trou est du silicium polycristallin, dans l'étape c).

Avantageusement, le procédé de fabrication comporte une étape qui a lieu après l'étape c) et dans laquelle on soumet la plaquette ou le composant électromécanique à des conditions qui sont identiques à des conditions utilisées pour effectuer une oxydation thermique de silicium.

Avantageusement, au moins lors des étapes a) à c), la plaquette fait partie d'un wafer (tel qu'un wafer de type SOI) dans lequel la plaquette comprend une première face principale unie à un support et une deuxième face principale opposée à la première face principale. Avantageusement, le procédé de fabrication comprend une étape qui a lieu après l'étape c) et dans laquelle on polit la deuxième face principale de la plaquette.

Avantageusement, on réalise au moins l'une des étapes a) et d) par gravure.

Avantageusement, au moins lors des étapes a) à c), la plaquette fait partie d'un wafer (tel qu'un wafer de type SOI) dans lequel une face principale de la plaquette est unie à un support. Avantageusement, le procédé de fabrication comprend une étape dans laquelle le composant est débarrassé du support. Cette étape a lieu après l'étape c), par exemple directement après cette étape c) ou directement après l'étape d).

### Brève description des dessins

D'autres avantages et caractéristiques ressortiront plus clairement de la description qui va suivre de modes particuliers de réalisation de l'invention donnés à titre d'exemple non limitatif et représentés aux dessins annexés, parmi lesquels :
- la figure 1 est une vue schématique, de côté, d'un actionneur électrostatique connu ;
- la figure 2A est une vue schématique, en perspective, d'un composant électromécanique selon un premier mode de réalisation de l'invention ;
- la figure 2B est une vue schématique, de côté, qui représente le composant de la figure 2A au repos, ainsi que sa déformation (volontairement exagérée à des fins illustratives) lorsqu'une tension lui est appliquée ;
- la figure 3 est une vue schématique, en perspective, d'une portion d'un composant électromécanique selon un deuxième mode de réalisation de l'invention ;
- les figures 4A à 4F sont des vues partielles, en coupe selon le plan IV de la figure 3, à différents instants au cours de l'exécution d'un procédé de fabrication conforme à l'invention, et illustrent chacune un état intermédiaire entre deux étapes successives de ce procédé, lors de la fabrication du composant partiellement représenté à la figure 3 ;
- la figure 5 est une vue schématique, de côté, d'un composant électromécanique selon un troisième mode de réalisation de l'invention ;
- la figure 6 est une vue schématique, de côté, d'un composant électromécanique selon un quatrième mode de réalisation de l'invention ;
- la figure 7 est une vue schématique, de côté, d'un composant électromécanique selon un cinquième mode de réalisation de l'invention ;
- la figure 8 est une vue schématique, de côté, d'un composant électromécanique selon un sixième mode de réalisation de l'invention ;
- la figure 9 est une vue schématique, de côté, d'une portion d'un composant électromécanique selon un septième mode de réalisation de l'invention ;
- la figure 10 est une vue schématique, de côté, d'une portion d'un composant électromécanique selon un huitième mode de réalisation de l'invention ;
- la figure 11 est une vue schématique, en perspective, d'une portion d'un composant électromécanique selon un neuvième mode de réalisation de l'invention ;
- la figure 12A est une vue schématique et partielle, de côté, avec arrachement, d'un composant électromécanique selon un dixième mode de réalisation de l'invention ;
- la figure 12B est une vue schématique et partielle, de côté, avec arrachement, d'un composant électromécanique selon un onzième mode de réalisation de l'invention ; et
- la figure 12C est une vue schématique et partielle, de côté, avec arrachement, d'un composant électromécanique selon un douzième mode de réalisation de l'invention.

Sur ces figures 1, 2A, 2B, 3, 4A à 4F, 5 à 11, 12A, 12B et 12C, les proportions ne sont pas respectées, dans un souci de clarté.

### Description de modes de réalisation de l'invention

La figure 2A représente un composant électromécanique 1 selon un premier mode de réalisation de l'invention. Ce composant 1 est plus précisément un composant électrostatique et peut notamment être utilisé comme actionneur électromécanique, comme générateur électrique ou comme capteur capacitif. Le composant 1 peut également être connecté à un composant électronique actif, au sein d'un oscillateur dans lequel ses modes actionneur et générateur sont amenés à alterner à une fréquence d'oscillation.

Le composant 1 comporte une première électrode E1 et une deuxième électrode E2, dont chacune a la forme d'une lame. Une couche diélectrique C1 lie mécaniquement ces première et deuxième électrodes E1 et E2 l'une à l'autre, tout en les isolant électriquement l'une de l'autre.

Le composant 1 possède la forme d'une lame allongée, qui est élastiquement flexible dans un plan de flexion P, sur toute sa longueur. Le composant 1 pourrait toutefois comporter une ou plusieurs portions non flexibles, en plus d'au moins une portion élastiquement flexible. La première électrode E1, la deuxième électrode E2 et la couche diélectrique C1 s'étendent sur toute la longueur du composant 1. En variante, chacune d'entre elles pourrait s'étendre sur seulement une partie de la longueur du composant 1.

La couche diélectrique C1 s'étend selon une surface cannelée et, dans le composant 1, sa section selon le plan de flexion P est constituée d'une succession de créneaux. La couche diélectrique C1 comporte plusieurs tronçons 3 qui sont particuliers en ce qu'ils sont non parallèles à la fibre moyenne ℓ selon laquelle s'étend le composant 1 ou, plus généralement, la section de celui-ci selon le plan de flexion P.

La première électrode E1 est plus épaisse que la deuxième électrode E2. La couche diélectrique C1 est de ce fait excentrée, en étant plus proche de l'une des deux faces principales du composant 1 que de l'autre face principale de celui-ci. Dans le même but, la deuxième électrode E2 pourrait être plus épaisse que la première électrode E1.

Dans le composant 1, la première électrode E1 et la deuxième électrode E2 sont réalisées en un même matériau, appelé premier matériau dans ce qui suit. Ce premier matériau est électriquement conducteur. Par exemple, ce peut être du silicium monocristallin ou polycristallin dopé. De préférence, le premier matériau est du silicium monocristallin A dopé.

La couche diélectrique C1 est réalisée en un deuxième matériau qui est différent du premier matériau et qui est isolant électriquement. Lorsque le premier matériau est du silicium monocristallin ou polycristallin, le deuxième matériau est de préférence de l'oxyde de silicium B. Cet oxyde de silicium est plus précisément de l'oxyde de silicium amorphe (SiO₂). L'épaisseur e de la couche diélectrique C1 peut être constante. Elle peut également ne pas être partout la même.

La première électrode E1 porte une borne de connexion 5, qui lui est connectée électriquement. La deuxième électrode E2 porte une borne de connexion 6, qui lui est connectée électriquement. Les bornes de connexion 5 et 6 permettent de connecter électriquement le composant 1 dans un circuit électrique, par exemple au moyen de raccordements électriques selon la technique appelée pontage (bonding en anglais). Chacune des bornes de connexion 5 et 6 est métallique et peut être réalisée notamment en or ou en aluminium. Chacune des bornes de connexion 5 et 6 peut également être réalisée en un autre métal ou en un alliage.

Le plan de flexion P est le plan de la feuille à la figure 2B. Lorsque l'on applique une tension électrique entre les première et deuxième électrodes E1 et E2, ces première et deuxième électrodes E1 et E2 se chargent différemment, l'une positivement et l'autre négativement, et elles s'attirent mutuellement. De ce fait, la couche diélectrique C1 est compressée et son épaisseur e est diminuée. La compression des tronçons particuliers 3 dans le sens de leur épaisseur e se traduit par une contraction longitudinale d'une moitié du composant 1, cette moitié étant celle où se trouve la couche diélectrique C1. La localisation de la contraction surtout sur une moitié du composant 1 amène ce composant 1 à se cintrer dans le plan de flexion P et à adopter la forme représentée en traits discontinus à la figure 2B, sur laquelle la forme en traits continue est celle du composant 1 avant l'application de la tension électrique. En se cintrant au moment de l'application d'une tension électrique entre ses première et deuxième électrodes E1 et E2, le composant 1 se comporte en actionneur.

Si le composant 1 est cintré dans le plan de flexion P de manière à adopter la forme représentée en traits discontinus à la figure 2B parce qu'on lui applique une force extérieure, une moitié longitudinale du composant 1 est sollicitée en compression, tandis que l'autre moitié longitudinale du composant 1 est sollicitée en traction. Sur la figure 2B, la moitié sollicitée en compression est celle où se trouve la couche diélectrique C1, tandis que la moitié sollicitée en traction est celle où la couche diélectrique C1 est absente. La compression de la couche diélectrique C1 se traduit par une réduction de son épaisseur e au niveau des tronçons particuliers 3 et donc par une augmentation de la capacité du composant 1.

Tout en l'étant encore dans le plan de flexion P et par une force extérieure, le composant 1 peut également être cintré dans le sens inverse de celui conduisant à la déformation représentée en trait discontinu à la figure 2B. Dans ce cas, la moitié longitudinale sollicitée en traction est celle où se trouve la couche diélectrique C1. La sollicitation en traction de cette moitié se traduit par une augmentation de l'épaisseur e de la couche diélectrique C1 au niveau de ses tronçons particuliers 3 et donc par une diminution de la capacité du composant 1.

La variation de la capacité du composant 1 peut être utilisée pour générer un courant électrique. La variation de la capacité du composant 1 peut également être utilisée pour employer ce composant 1 comme capteur.

Par exemple, le composant 1 peut faire partie d'un capteur de fin de course ou d'un capteur de détection d'une présence au niveau d'un emplacement. Le composant 1 peut aussi faire partie d'un accéléromètre, auquel cas une masse d'inertie peut y être fixée ou lui être autrement accouplée. La finalité d'une masse lestant le composant électromécanique 1 peut également être de modifier la fréquence propre de l'ensemble.

Pour fabriquer le composant électromécanique 1, on peut utiliser, par exemple, le procédé suivant :
- Ouverture, dans le premier matériau, d'espaces (des tranchées) destinés à recevoir le deuxième matériau : au moyen de la gravure ionique réactive profonde encore appelée gravure DRIE (acronyme de la désignation anglaise « *Deep reactive ion etching* »), on grave les espaces dans une plaque en le premier matériau, ces espaces étant destinés à recevoir le deuxième matériau. Une solution préférentielle consiste à utiliser un wafer SOI (assemblage silicium-oxyde de silicium) et à graver la partie supérieure en silicium (ce qu'on appelle un « device layer »). De cette manière, l'épaisseur du composant 1 correspondra à l'épaisseur de ce « device layer ».
- Remplissage avec le deuxième matériau : de manière préférentielle, on remplit les espaces gravés avec de l'oxyde thermique. Cet oxyde est formé automatiquement à partir du silicium dans un four tel qu'un four à atmosphère humide. Après un certain temps dans le four, l'oxyde remplit totalement les cavités. Des techniques de dépôt en phase vapeur peuvent également être employées pour effectuer le remplissage.
- Détourage du pourtour du composant : après des étapes de photolithographie, une nouvelle gravure DRIE détoure complètement le composant 1 dans le plan. De manière préférentielle, le composant 1 est totalement détouré à l'exception d'une éventuelle attache qui le rend solidaire du wafer et qui sera brisée en fin de procédé. Pour certaines exécutions, cette étape de détourage peut être effectuée en même temps que l'étape 1, c'est-à-dire en même temps que l'ouverture d'espaces dans le premier matériau.

- Libération du composant : dans cette étape, on retire la face arrière du wafer SOI. Ce retrait peut se faire soit uniquement sous le ou les composants 1, soit sur toute la surface du wafer.
- Post-traitements : des post-traitements (p.ex. des dépôts supplémentaires ou des traitements de la surface) peuvent être réalisés afin d'augmenter la résistance du composant 1 aux chocs, d'augmenter la conductivité électrique et/ou d'ajuster ou changer le module d'élasticité du composant 1, etc.

Le composant 1 peut être modifié de diverses manières sans sortir du cadre de l'invention. D'autres modes de réalisation sont proposés de manière non exhaustive dans ce qui suit.

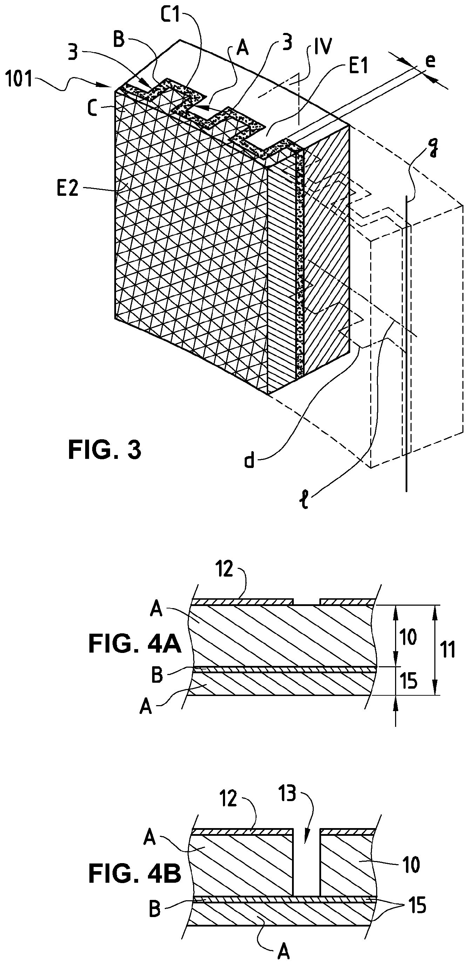

La figure 3 représente partiellement un composant électromécanique 101 selon un deuxième mode de réalisation de l'invention. Dans ce composant 101, la première électrode E1 est réalisée en un premier matériau, tandis que la couche diélectrique C1 est réalisée en un deuxième matériau et que la deuxième électrode E2 est réalisée en un troisième matériau différent des premier et deuxième matériaux. Le premier matériau est électriquement conducteur. Par exemple, ce peut être du silicium dopé. De préférence, le premier matériau est du silicium monocristallin A dopé. Le troisième matériau est électriquement conducteur. Par exemple, ce peut être du silicium dopé. De préférence, le troisième matériau est du silicium polycristallin C dopé.

De préférence, le composant 101 comporte une première électrode E1 en silicium monocristallin A dopé et une deuxième électrode E2 en silicium polycristallin C dopé, entre lesquelles la couche diélectrique C1 est en oxyde de silicium B. Toutefois, d'autres matériaux peuvent être utilisés. En particulier, le troisième matériau peut ne pas être du silicium polycristallin. En effet, la deuxième électrode E2 peut être réalisée en tout matériau approprié, notamment en tout matériau approprié déposable en couche épaisse, notamment par un dépôt physique en phase vapeur encore appelé dépôt PVD (acronyme de la désignation anglaise « *Physical Vapor Déposition* ») ou bien par un dépôt chimique en phase vapeur encore appelé dépôt CVD (acronyme de la désignation anglaise « *Chemical Vapor Deposition* »). Par exemple, la deuxième électrode E2 peut être réalisée en SiC, Al, Ti, Au, W.

Toujours sur la figure 3, la couche diélectrique C1 s'étend selon une ligne directrice d et parallèlement à une génératrice 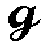 coupant le plan de flexion P. Les expressions « ligne directrice » et « génératrice » ont ici le sens qu'on leur donne en mathématiques, notamment pour décrire des surfaces cylindriques. La génératrice 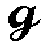 est donc une droite. De préférence, elle est perpendiculaire ou sensiblement perpendiculaire au plan de flexion P.

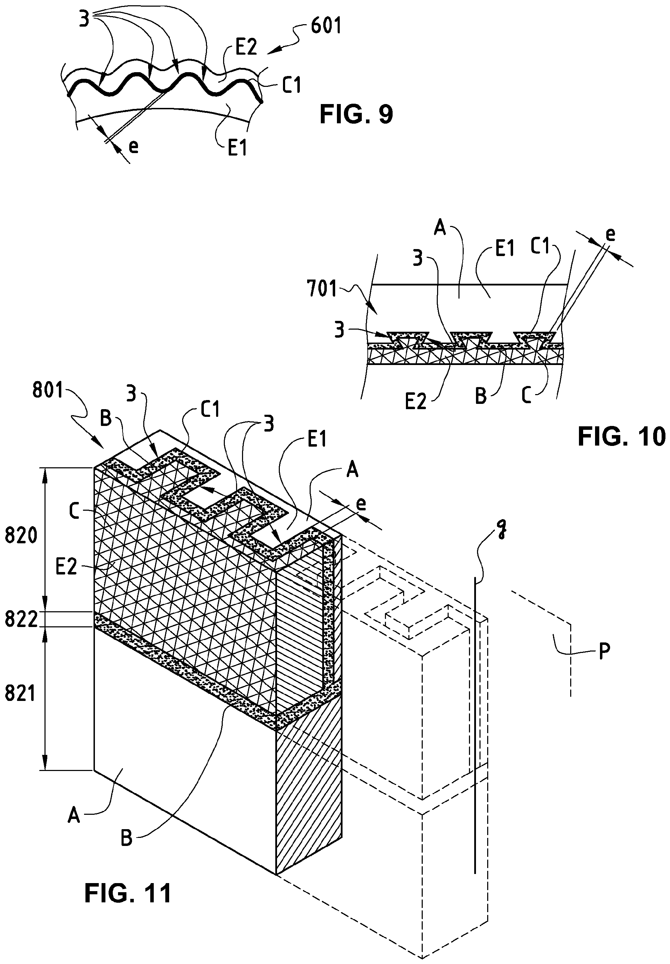

Ce qu'expose le paragraphe précédent au sujet de la couche diélectrique C1 du composant 101 vaut également pour la ou chaque couche diélectrique C1 ou C2 des autres modes de réalisation de l'invention proposés dans la présente description, à ceci près que la génératrice 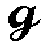 est parallèle ou sensiblement parallèle au plan de flexion P dans le composant électromécanique 801 partiellement représenté à la figure 11.

Le composant 101 peut être réalisé en mettant en œuvre un procédé de fabrication conforme à l'invention. Un mode de réalisation de ce procédé de fabrication va maintenant être décrit à l'aide des figures 4A à 4F. Le composant 101 y est fabriqué à partir d'une plaquette 10 faite de silicium monocristallin A. De préférence, cette plaquette 10 fait partie d'un wafer 11 de type silicium-oxyde-silicium, l'acronyme anglais « SOI » étant aussi communément utilisé pour désigner ce type de wafer. En variante, le matériau de la plaquette 10 peut être du silicium polycristallin C.

Sur la plaquette 10 en silicium monocristallin A, on forme un masque de gravure 12 en déposant une couche en résine photosensible, puis en solubilisant et en retirant ensuite des portions de cette couche en résine photosensible. L'état qui résulte du dépôt du masque de gravure 12 est celui représenté à la figure 4A.

Pour passer de l'état représenté à la figure 4A à l'état représenté à la figure 4B, on grave la plaquette 10 à l'aide du masque de gravure 12, de manière à former un trou 13 dans cette plaquette 10, sur toute son épaisseur. Pour ce faire, on utilise la gravure ionique réactive profonde, encore appelée gravure DRIE (acronyme de la désignation anglaise « *Deep reactive ion etching* »). Les contours du trou 13 sont ceux de la deuxième électrode E2 dans la pièce finie, au moins du côté de ce qui est destiné à former la première électrode E1.

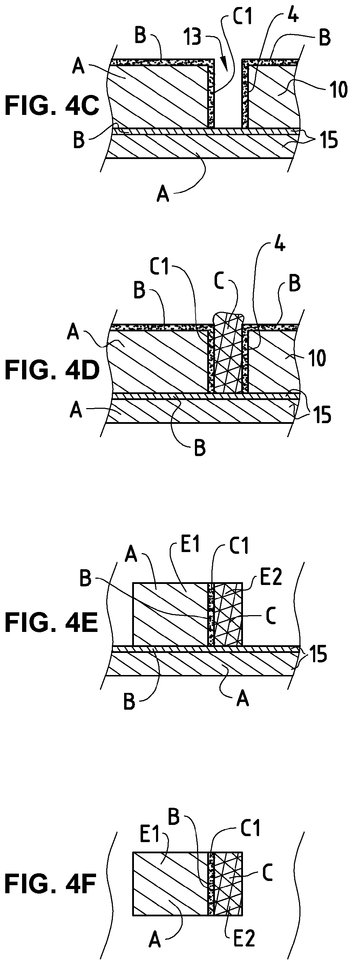

Pour passer de l'état représenté à la figure 4B à l'état représenté à la figure 4C, on crée la couche diélectrique C1 en oxyde de silicium B au niveau de la partie découverte de la surface de la plaquette 10 et, en particulier, au niveau de la paroi du trou 13. La couche diélectrique C1 peut notamment être réalisée par oxydation thermique, dans un four où l'oxyde de silicium se forme à partir du silicium. L'oxydation thermique peut être une oxydation humide obtenue en présence de vapeur d'eau dans le four ou bien une oxydation sèche obtenue en présence de dioxygène dans le four. La couche diélectrique C1 peut également être déposée, par exemple au moyen d'un dépôt physique en phase vapeur.

Pour passer de l'état représenté à la figure 4C à l'état représenté à la figure 4D, on remplit le trou 13 avec du silicium polycristallin C. De préférence, cela est réalisé au moyen d'un dépôt directionnel, qui peut être un dépôt PVD ou bien un dépôt CVD. Le dopage du silicium polycristallin C peut être réalisé au moyen d'une technique connue en soi, dans laquelle il a lieu en même temps que le dépôt de ce silicium polycristallin C. Ensuite, on procède à un traitement qui, d'après la compréhension actuelle des premiers résultats obtenus, renforce la liaison mécanique entre l'oxyde de silicium B de la couche diélectrique C1 et le silicium polycristallin C de la deuxième électrode E2. Ce traitement consiste à soumettre l'ensemble, c'est-à-dire la plaquette 10 avec l'oxyde de silicium B et avec le silicium polycristallin C dans le trou 13, à des conditions qui pourraient être utilisées pour produire une oxydation thermique de silicium. Ces conditions peuvent être identiques à des conditions utilisées pour effectuer une oxydation thermique humide ou bien elles peuvent être identiques à des conditions utilisées pour effectuer une oxydation thermique sèche.

Pour passer de l'état représenté à la figure 4C à l'état représenté à la figure 4D, on peut également remplir le trou 13 avec un matériau autre que le silicium polycristallin. En particulier, on peut remplir le trou 13 avec tout matériau approprié déposable en couche épaisse, notamment par PVD ou par CVD. Par exemple, on peut remplir le trou 13 avec au moins l'un des matériaux suivant : SiC, Al, Ti, Au, W.

Pour passer de l'état représenté à la figure 4D à l'état représenté à la figure 4E, on réalise deux opérations, qui sont un polissage de la face apparente de la plaquette 10 et un détourage du composant 101. Le polissage peut être une planarisation mécano-chimique encore appelée procédé CMP (acronyme de la désignation anglaise « *Chemical Mechanical Planarization* »). Ce polissage retire l'excès de silicium polycristallin C, ainsi que l'oxyde de silicium B au niveau de l'une des faces principales de la plaquette 10. Le détourage consiste à découper le composant 101 et il est réalisé au moyen d'un masque de gravure non représenté et d'une gravure DRIE. De préférence, le composant 101 est totalement détouré sauf au niveau d'une attache éventuelle qui l'unit au reste de la plaquette 10. Cette attache sera brisée plus tard. Lors du détourage, la partie résiduaire 4 de la couche d'oxyde de silicium B est de préférence retirée au moyen d'une gravure chimique humide. Tel est notamment le cas lorsque, au lieu d'être du silicium polycristallin C, le matériau de remplissage du trou 13 est un matériau ne pouvant pas être gravé au moyen d'une gravure DRIE. Lorsque le matériau de remplissage du trou 13 est du silicium polycristallin C, le détourage du composant électromécanique peut se faire selon un contour passant dans ce silicium polycristallin C, par gravure DRIE et sans gravure chimique humide.

Pour passer de l'état représenté à la figure 4E à l'état représenté à la figure 4F, on libère le composant 101. Cela consiste à retirer localement ou à supprimer totalement, par exemple par gravure, la partie 15 du wafer 11, c'est-à-dire la partie qui forme un support pour la plaquette 10.

Un ou plusieurs post-traitements peuvent être ensuite appliqués. Ce ou ces post-traitements peuvent notamment être choisis parmi :
- un dépôt ou un traitement visant à augmenter la résistance au choc du composant 101 ;
- un dépôt ou un traitement visant à augmenter la conductivité électrique des électrodes du composant 101 ;
- un dépôt ou un retrait de matière visant à ajuster ou changer la raideur en flexion du composant 101.

Le ou l'un des post-traitements appliqué au composant 101 peut être une oxydation thermique produisant une couche superficielle d'oxyde de silicium B.

Le procédé exposé ci-dessus peut être appliqué pour réaliser simultanément plusieurs composants 101 à partir d'un seul et même wafer 11. Par ailleurs, il peut comporter une ou plusieurs autres étapes en plus de celles qui ont été explicitées ci-dessus. En particulier, le procédé de fabrication du composant 101 peut comporter une ou plusieurs étapes additionnelles lors desquelles ce composant est achevé. L'une de ces étapes additionnelles peut être la pose de bornes de connexion telles que les bornes de connexion 5 et 6. Une autre étape parmi les étapes additionnelles peut être l'encapsulation du composant 101.

Une très grande précision sur l'épaisseur e de la couche diélectrique C1 en oxyde de silicium B peut être obtenue lorsque le composant électromécanique est réalisé en mettant en œuvre le procédé de fabrication qui vient d'être décrit en se référant aux figures 4A à 4F.

On a constaté que, de manière surprenante, la deuxième électrode E2 en silicium polycristallin est fermement liée à la couche diélectrique C1 en oxyde de silicium.

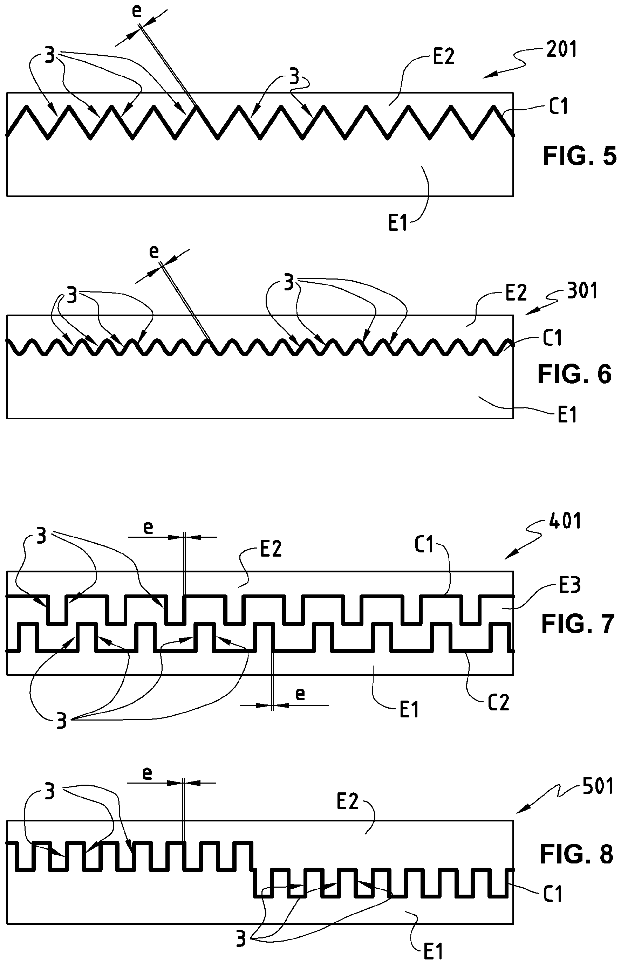

La couche diélectrique C1 séparant la première électrode E1 de la deuxième électrode E2 peut posséder diverses formes autres que celle qu'elle a dans les composants 1 et 101. Par exemple, sur la figure 5, la couche diélectrique C1 s'étend selon une ligne directrice en dent de scie dans un composant électromécanique 201 selon un troisième mode de réalisation de l'invention. Sur la figure 6, la couche diélectrique C1 a la forme d'une succession de vagues dans un composant électromécanique 301 selon un quatrième mode de réalisation de l'invention.

Egalement, plus de deux électrodes peuvent être présentes dans un composant électromécanique conforme à l'invention. La figure 7 représente un composant électromécanique 401 selon un cinquième mode de réalisation de l'invention. Ce composant 401 comporte trois électrodes E1, E2 et E3, ainsi que deux couches diélectriques C1 et C2. Lorsque le composant 401 est tordu par une force extérieure, les couches diélectriques C1 et C2 connaissent des types de déformation inverses. Par exemple, si la région avec la couche diélectrique C1 est étirée, la région avec la couche diélectrique C2 est comprimée.

Sans sortir du cadre de l'invention, le décentrage de la couche diélectrique C1 peut être modifié, voire inversé, le long du composant électromécanique. En particulier, il peut être modifié de manière que, en mode actionneur, le composant électromécanique se déforme d'une manière spécifique. Une inversion du décentrage peut également permettre d'optimiser la sensibilité du capteur lorsque le composant électromécanique est employé comme capteur capacitif. La figure 8 montre un composant électromécanique 501 selon un sixième mode de réalisation de l'invention. Dans ce composant 501, une inversion du décentrage de la couche diélectrique C1 permet d'obtenir une déformation en forme de « S », en mode actionneur. Lorsqu'il est utilisé comme capteur, le composant électromécanique 501 est monté de manière qu'un déplacement relatif amène ce composant électromécanique 501 à adopter la forme d'un « S » ou une forme approchante. Lorsque le composant électromécanique 501 est employé de la sorte, sa sensibilité rapportée à ses dimensions est élevée.

La figure 9 représente partiellement un composant électromécanique 601 selon un septième mode de réalisation de l'invention. Sans sortir du cadre de l'invention, le composant électromécanique peut posséder un contour extérieur présentant des formes diverses, en particulier des formes tendant à faciliter sa déformation et/ou à déterminer son mode de déformation, ce qui est le cas du composant 601.

Toujours sans sortir du cadre de l'invention, le composant électromécanique au repos, c'est-à-dire en l'absence de sollicitation extérieure, peut ne pas être rectiligne ou ne pas être plan. Tel est encore le cas du composant 601, qui est courbe au repos.

La figure 10 représente partiellement un composant électromécanique 701 selon un huitième mode de réalisation de l'invention. Le composant électromécanique 701 se distingue du composant électromécanique 101 en ce que les créneaux successifs que forme sa couche diélectrique C1 ont chacun la forme d'un contour de queue d'aronde, ce qui a pour avantage de renforcer l'assujettissement de la première électrode E1, de la couche diélectrique C1 et de la deuxième électrode E2 les unes aux autres, du fait de la présence de zones en contre-dépouille, et d'accroître ainsi la robustesse du composant électromécanique 701.

Dans les composants électromécanique 201, 301, 401, 501, 601 et 701, le matériau de la première électrode E1, le matériau de la deuxième électrode E2 et le matériau de la couche diélectrique C1 peuvent être les mêmes que dans le composant électromécanique 1. Egalement, dans les composants électromécaniques 201, 301, 401, 501, 601 et 701, le matériau de la première électrode E1, le matériau de la deuxième électrode E2 et le matériau de la couche diélectrique C1 peuvent être les mêmes que dans le composant électromécanique 101.

La figure 11 représente partiellement un composant électromécanique 801 selon un neuvième mode de réalisation de l'invention. Le composant 801 présente la structure d'un empilement d'étages liés mécaniquement entre eux, parmi lesquels un premier étage 820 est constitué de la première électrode E1, de la deuxième électrode E2 et de la couche diélectrique C1. Un deuxième étage du composant 801 est un étage 821 en silicium. Un troisième étage du composant 801 est fait d'oxyde de silicium. Il s'agit d'un étage de séparation 822 qui lie mécaniquement le premier et le deuxième étage l'un à l'autre tout en les isolant électriquement l'un de l'autre.

Le plan de flexion P du composant 801 est parallèle à la génératrice 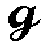 parallèlement à laquelle s'étend la couche diélectrique C1. Lorsque le composant 801 est cintré dans ce plan de flexion P par une force extérieure, le premier étage 820 et l'étage 821 sont sollicités l'un entièrement ou majoritairement en compression et l'autre entièrement ou majoritairement en traction. La mise en compression ou en traction de la totalité ou de la majorité du premier étage 820 fait que l'épaisseur e de la couche diélectrique C1 est modifiée au niveau des tronçons particuliers 3, ce qui se traduit par une variation de la capacité du composant électromécanique 801.

Lorsque, en mode actionneur, une tension est appliquée entre la première électrode E1 et la deuxième électrode E2, la compression des tronçons particuliers 3 dans le sens de leur épaisseur e du fait de l'attraction mutuelle de ces première et deuxième électrodes E1 et E2 se traduit par une contraction longitudinale du premier étage 820. L'étage 821 subit une contraction longitudinale moindre que ce premier étage 820, ce qui amène le composant 801 à se cintrer dans le plan de flexion P.

Le composant 801 peut être réalisé à partir d'un wafer 11 de type silicium-oxyde-silicium (wafer SOI), en mettant en œuvre un procédé de fabrication conforme à l'invention. Un mode de réalisation de ce procédé de fabrication comporte des premières étapes qui sont les mêmes que les premières étapes du procédé qui a été décrit précédemment à l'aide des figures 4A à 4F. Ces premières étapes communes aux deux modes de réalisation du procédé de fabrication conforme à l'invention sont celles qui précèdent le détourage du composant. Elles comprennent les étapes menant de l'état de la figure 4A jusqu'à l'état de la figure 4D, ainsi que le polissage de la face apparente de la plaquette 10.

La fabrication du composant 801 comprend également un détourage, lors duquel ce composant 801 est découpé dans toute l'épaisseur du wafer 11, y compris dans le support 15 en silicium et en oxyde de silicium. Lors du détourage du composant 801, l'étage 821 et l'étage de séparation 822 sont ainsi découpés dans le support 15. Le détourage est réalisé au moyen d'un masque de gravure non représenté et d'une combinaison de deux types de gravure qui sont la gravure DRIE pour découper dans le silicium et la gravure chimique humide ou sèche pour découper dans les parties en oxyde de silicium. De préférence, le composant 801 est totalement détouré sauf au niveau d'une attache éventuelle qui l'unit au reste du wafer 11 et qui sera brisée plus tard.

La fabrication du composant 801 ne comporte pas de libération du composant, c'est-à-dire d'étape consistant à retirer le support 15 au moins au niveau de la première électrode E1, de la deuxième électrode E2 et de la couche diélectrique C1. De la sorte, l'étage 821 et l'étage de séparation 822, qui appartenait au support 15, restent présents dans le composant 801.

En plus des étapes qui ont été explicitées ci-dessus, le procédé de fabrication du composant 801 peut comporter une ou plusieurs autres étapes, en particulier un ou plusieurs post-traitements et/ou une ou plusieurs étapes lors desquelles le composant est achevé. Par ailleurs, le procédé exposé ci-dessus peut être appliqué pour réaliser simultanément plusieurs composants 801 à partir d'un seul et même wafer 11.

Le « coefficient thermique du module d'Young » décrit la variation du module d'élasticité d'un matériau en fonction de la température. Afin d'obtenir une compensation thermique s'appliquant sur la raideur en flexion du composant électromécanique selon l'invention, il est possible de choisir les premier et deuxième matériaux ou deux des premier, deuxième et troisième matériaux de manière que leurs coefficients thermiques du module de Young soient de signes opposés. Dans chacun de ces deux cas, il est également possible d'ajuster la proportion des matériaux présents dans le composant électromécanique de manière que la thermocompensation obtenue soit telle que la raideur en flexion du composant électromécanique selon l'invention soit très peu dépendante, voire indépendante, des variations de température.

Par exemple, le coefficient thermique du module de Young du silicium monocristallin A et celui du silicium polycristallin C sont l'un et l'autre négatifs, tandis que le coefficient thermique du module de Young de l'oxyde de silicium est quant à lui positif. De ce fait, lorsque les première et deuxième électrodes E1 et E2 sont réalisées en silicium et que la couche diélectrique C1 est réalisée en oxyde de silicium, la présence de l'oxyde de silicium au sein du silicium produit une compensation thermique concernant la raideur en flexion du composant électromécanique selon l'invention. Cette compensation thermique peut être ajustée de manière que la raideur en flexion du composant électromécanique selon l'invention soit très peu dépendante, voire indépendante, des variations de température.

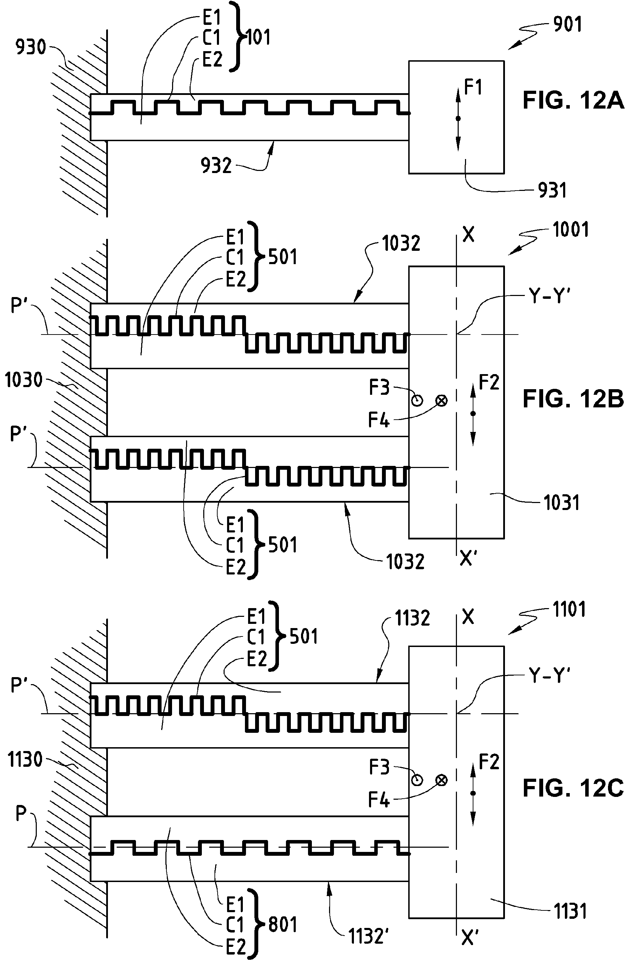

La figure 12A représente un composant électromécanique 901 selon un dixième mode de réalisation de l'invention. Ce composant électromécanique 901 comporte un châssis 930, une masse d'inertie 931, ainsi que plusieurs portions élastiquement flexibles 932 dont chacune est identique au composant électromécanique 101. Sur la figure 12A, une portion élastiquement flexible 932 masque la ou les autres portions élastiquement flexibles 932. Elle constitue une première sous-partie du composant électromécanique 901. Une autre portion élastiquement flexible 932 parmi les portions élastiquement flexibles 932 constitue une deuxième sous-partie du composant électromécanique 901.

Chaque portion élastiquement flexible 932 peut présenter la forme d'une lame. La liaison entre le châssis 930 et l'une des deux extrémités de chaque portion élastiquement flexible 932 est du type encastrement. La liaison entre l'autre extrémité de chaque portion élastiquement flexible 932 et la masse d'inertie 931 est également du type encastrement. Par exemple, la masse d'inertie 931 peut être monobloc avec une partie de chaque portion élastiquement flexible 932.

Lorsque le composant électromécanique 901 est employé comme oscillateur, comme générateur ou comme capteur capacitif, par exemple comme accéléromètre, la masse d'inertie 931 peut être déplacée par rapport au châssis 930, dans chacun des sens contraires indiqués par la double flèche F1. Par exemple, dans le cas d'une utilisation comme accéléromètre, les déplacements de la masse d'inertie 931 sont causés par des forces d'inertie s'appliquant sur cette masse d'inertie 931. Lors d'un basculement de la masse d'inertie 931 dans l'un des deux sens indiqués par la double flèche F1, chaque portion élastiquement flexible 932 est cintrée, ce qui se traduit par une variation des capacités entre les premières électrodes E1 et les deuxièmes électrodes E2.

Lorsque le composant électromécanique 901 est employé comme actionneur, les portions élastiquement flexibles 932 se cintrent ensemble et déplacent ensemble la masse d'inertie 931 par rapport au châssis 930, dans l'un des sens contraires indiqués par la double flèche F1.

Lors d'un déplacement de la masse d'inertie 931 dans l'un des deux sens indiqués par la double flèche F1, les portions élastiquement flexibles 932 se cintrent dans des plans de flexion parallèles entre eux, ces plans de flexion étant parallèles au plan de la feuille à la figure 12A. La masse d'inertie 931 réalise un accouplement qui favorise une synchronisation des cintrages des portions élastiquement flexibles 932 dans les plans de flexion parallèles au plan de la feuille à la figure 12A. Lorsque le composant électromécanique 901 est employé autrement que comme oscillateur ou que comme accéléromètre, la masse d'inertie 931 conserve sa fonction d'accouplement des portions élastiquement flexible 932, mais elle ne remplit pas véritablement une fonction de masse d'inertie et peut être allégée.

En variante, chacune des portions élastiquement flexibles 932 peut être identique à l'un des composants électromécaniques 1, 201, 301, 401, 601, 701 et 801. Selon une autre variante, les portions élastiquement flexibles 932 peuvent ne pas être identiques entre elles.

Selon encore une autre variante, le composant électromécanique 901 peut ne comporter qu'une seule portion élastiquement flexible 932 identique à l'un des composants électromécaniques 1, 101, 201, 301, 401, 601, 701 et 801.

La figure 12B représente un composant électromécanique 1001 selon un onzième mode de réalisation de l'invention. Ce composant électromécanique 1001 comporte un châssis 1030, une masse d'inertie 1031, ainsi que plusieurs portions élastiquement flexibles 1032 dont chacune est identique au composant électromécanique 501. Dans l'exemple représenté à la figure 12B, ces portions élastiquement flexibles 1032 sont au nombre de 2. Toutefois, elles peuvent être plus nombreuses. L'une et l'autre portion élastiquement flexible 1032 constituent respectivement une première et une deuxième sous-partie du composant électromécanique 1001.

La liaison entre le châssis 1030 et l'une des deux extrémités de chaque portion élastiquement flexible 1032 est du type encastrement. La liaison entre l'autre extrémité de chaque portion élastiquement flexible 1032 et la masse d'inertie 1031 est également du type encastrement. Par exemple, la masse d'inertie 1031 peut être monobloc avec une partie de chaque portion élastiquement flexible 1032.

Lorsque le composant électromécanique 1001 est employé comme oscillateur, comme générateur ou comme capteur, par exemple comme accéléromètre, la masse d'inertie 1031 peut être translatée par rapport au châssis 1030, dans chacun des sens contraires indiqués par la double flèche F2. Par exemple, dans le cas d'une utilisation comme accéléromètre, les déplacements de la masse d'inertie 1031 sont causés par des forces d'inertie s'appliquant sur cette masse d'inertie 1031. Lors d'une translation de la masse d'inertie 1031 dans l'un des deux sens indiqués par la double flèche F2, chaque portion élastiquement flexible 1032 adopte une forme comprenant deux cintrages dont les courbures sont inversées entre elles, l'inversion du cintrage étant localisée sensiblement dans la zone où le décentrage de la couche diélectrique C1 s'inverse. Lors d'une translation de la masse d'inertie 1031 dans l'un des deux sens indiqués par la double flèche F2, le double cintrage de la portion élastiquement flexible 1032 se traduit par une variation des capacités entre les premières électrodes E1 et les deuxièmes électrodes E2.

Lorsque le composant électromécanique 1001 est employé comme actionneur, les portions élastiquement flexibles 1032 se cintrent ensemble, chacune en deux zones et avec une inversion de la courbure entre ces deux zones, et déplacent ensemble la masse d'inertie 1031 par rapport au châssis 1030, dans l'un des sens contraires indiqués par la double flèche F2.

Lors d'une translation de la masse d'inertie 1031 dans l'un des deux sens indiqués par la double flèche F2, les portions élastiquement flexibles 1032 se cintrent dans un même plan de flexion, qui est commun à ces portions élastiquement flexibles 1032 et qui est parallèle au plan de la feuille à la figure 12B. La masse d'inertie 1031 réalise un accouplement faisant qu'il y a une synchronisation des déformations des portions élastiquement flexibles 1032 dans le plan de flexion commun. Lorsque le composant électromécanique 1001 est employé autrement que comme oscillateur ou que comme accéléromètre, la masse d'inertie 1031 conserve sa fonction d'accouplement des portions élastiquement flexible 1032, mais elle ne remplit pas véritablement une fonction de masse d'inertie et peut être allégée.

Le composant électromécanique 1001 peut être combiné à une structure à plans parallèles et ainsi appartenir à un composant électromécanique plus complexe qui comprend en outre cette structure à plans parallèles. Par exemple, le composant électromécanique 1001 peut être combiné à la structure à plans parallèles représentée à la figure 1. Lorsque tel est le cas, la masse d'inertie 1031 forme ou comporte une troisième électrode qui est mobile et qui correspond à l'électrode désignée par la référence E20 à la figure 1. De plus, une quatrième électrode est prévue. Elle est fixe et correspond à l'électrode désignée par la référence E10 à la figure 1. Les portions élastiquement flexibles 1032 correspondent à la partie formant ressort désignée par la référence R à la figure 1.

Toujours lorsque le composant électromécanique 1001 est combiné à la structure à plans parallèles représentée à la figure 1, les portions élastiquement flexibles 1032 peuvent être cintrées ensemble dans des plans de flexions parallèles P', qui sont perpendiculaires au plan de la feuille à la figure 12B. De la sorte, la masse d'inertie 1031 peut être déplacée par rapport au châssis 1030, dans chacun des sens contraires indiqués par les flèches F3 et F4.

Encore lorsque le composant électromécanique 1001 est combiné à la structure à plans parallèles représentée à la figure 1, une première capacité est la somme des capacités entre les premières électrodes E1 et les deuxièmes électrodes E2. Par exemple, une variation de cette première capacité peut servir à détecter et mesurer des accélérations selon la direction X-X'. Une deuxième capacité est la capacité entre les deuxième et troisième électrodes. Par exemple, une variation de cette deuxième capacité peut servir à détecter et mesurer des accélérations selon la direction Y-Y' perpendiculaire à la direction X-X'.

La figure 12C représente un composant électromécanique 1101 selon un douzième mode de réalisation de l'invention. Ce composant électromécanique 1101 comporte un châssis 1130, une masse d'inertie 1131, ainsi que deux portions élastiquement flexibles 1132 et 1132'.

La portion élastiquement flexible 1132 est identique au composant électromécanique 501. Elle constitue une première sous-partie du composant électromécanique 1101. La capacité entre les première et deuxième électrodes E1 et E2 de cette portion élastiquement flexible 1132 est une première capacité du composant électromécanique 1101.

La portion élastiquement flexible 1132' est identique au composant électromécanique 801. Elle constitue une deuxième sous-partie du composant électromécanique 1101. La capacité entre les première et deuxième électrodes E1 et E2 de cette portion élastiquement flexible 1132' est une deuxième capacité du composant électromécanique 1101.

Dans l'exemple représenté à la figure 12C, les portions élastiquement flexibles 1132 et 1032' sont au nombre de 2. Toutefois, elles peuvent être plus nombreuses.

La liaison entre le châssis 1130 et l'une des deux extrémités de chaque portion élastiquement flexible 1132 ou 1132' est du type encastrement. La liaison entre l'autre extrémité de chaque portion élastiquement flexible 1132 ou 1132' et la masse d'inertie 1131 est également du type encastrement. Par exemple, la masse d'inertie 1131 peut être monobloc avec une partie de chacune des portions élastiquement flexibles 1132 et 1132'.

Lorsque le composant électromécanique 1101 est employé comme capteur, par exemple comme accéléromètre, la masse d'inertie 1131 peut être déplacée par rapport au châssis 1130. Par exemple, dans le cas d'une utilisation comme accéléromètre, les déplacements de la masse d'inertie 1131 sont causés par des forces d'inertie s'appliquant sur cette masse d'inertie 1131. Par rapport au châssis 1130, la masse d'inertie 1131 peut être translatée dans chacun des sens contraires indiqués par la double flèche F2. Toujours par rapport au châssis 1130, la masse d'inertie 1131 peut également être basculée dans chacun des sens contraires indiqués par les flèches F3 et F4.

Lors d'une translation de la masse d'inertie 1131 dans l'un des deux sens indiqués par la double flèche F2, chacune des portions élastiquement flexibles 1132 et 1132' adopte une forme comprenant deux cintrages dont les courbures sont inversées entre elles. Dans la portion élastiquement flexible 1132, l'inversion du cintrage est localisée sensiblement dans la zone où le décentrage de la couche diélectrique C1 s'inverse. Lors d'une translation de la masse d'inertie 1131 dans l'un des deux sens indiqués par la double flèche F2, le double cintrage de la portion élastiquement flexible 1132 se traduit par une variation de la première capacité du composant électromécanique 1101. Il n'y a pas de variation de la deuxième capacité de ce composant électromécanique 1101 si le déplacement de la masse d'inertie 1131 est constitué seulement de la translation de celle-ci dans l'un des deux sens indiqués par la double flèche F2.

Lors d'un basculement de la masse d'inertie 1131 dans l'un des sens contraires indiqués par les flèches F3 et F4, les portions élastiquement flexibles 1132 et 1032' sont cintrées ensemble dans des plans de flexions parallèles P et P', qui sont perpendiculaires au plan de la feuille à la figure 12C. Toujours lors d'un basculement de la masse d'inertie 1131 dans l'un des sens contraires indiqués par les flèches F3 et F4, le cintrage de la portion élastiquement flexible 1132' se traduit par une variation de la deuxième capacité du composant électromécanique 1101. Il n'y a pas de variation de la première capacité de ce composant électromécanique 1101 si le déplacement de la masse d'inertie 1131 est constitué seulement du basculement de celle-ci dans l'un des sens contraires indiqués par les flèches F3 et F4.

Par exemple, une variation de la première capacité du composant électromécanique 1101 peut servir à détecter et mesurer des accélérations selon la direction X-X'. Par exemple, une variation de la deuxième capacité du composant électromécanique 1101 peut servir à détecter et mesurer des accélérations selon la direction Y-Y' perpendiculaire à la direction X-X'.

Lors d'une translation de la masse d'inertie 1131 dans l'un des deux sens indiqués par la double flèche F2, les portions élastiquement flexibles 1132 et 1132' sont doublement cintrées dans un même plan de flexion, qui est parallèle au plan de la feuille à la figure 12C. Ce plan de flexion est commun aux portions élastiquement flexibles 1132 et 1132'. La masse d'inertie 1131 réalise un accouplement qui fait que, lors d'une accélération selon la direction X-X', il y a une synchronisation des déformations des portions élastiquement flexibles 1132 et 1132' dans le plan de flexion commun parallèle au plan de la feuille à la figure 12C. L'accouplement réalisé par la masse d'inertie 1131 favorise en outre que, lors d'une accélération selon la direction Y-Y', il y ait une synchronisation des cintrages des portions élastiquement flexibles 1132 et 1132' dans les plans de flexion P et P' perpendiculaires au plan de la feuille à la figure 12C.

En variante, la ou chaque portion élastiquement flexible 1132' peut être identique à l'un des composants électromécaniques 1, 101, 201, 301, 401, 601 et 701. Selon une autre variante, les portions élastiquement flexibles 1132' peuvent ne pas être identiques entre elles.

Chacun des composants 1, 101, 201, 301, 401, 501, 601, 701, 801, 901, 1001 et 1101 peut être un microsystème électromécanique, c'est-à-dire faire partie des MEMS.

L'invention ne se limite pas aux modes de réalisation décrits précédemment. En particulier, une couche additionnelle se comportant comme une lame élastiquement flexible supplémentaire peut être ajoutée latéralement, par exemple du côté de la première électrode E1, et avoir le même effet que le non centrage de la couche diélectrique C1. En particulier, cette couche additionnelle peut posséder un module de Young supérieur au module de Young du matériau des première et deuxième électrodes ou à chacun des modules de Young des matériaux des première et deuxième électrodes. En d'autres termes, une couche additionnelle par exemple liée mécaniquement à un côté de la première électrode E1 peut faire ou contribuer à faire que, quand l'ensemble comprenant cette couche additionnelle, la couche diélectrique C1 et les première et deuxième électrodes E1 et E2 est cintrée par une force extérieure, les tronçons particuliers 3 de la couche diélectrique C1 se trouvent majoritairement ou complètement dans une région soumise à un seul type de sollicitation, par exemple dans une région en compression.

## Revendications

1. Composant électromécanique, comprenant au moins une première électrode (E1) et une deuxième électrode (E2),
une couche diélectrique (C1) liant mécaniquement la première (E1) et la deuxième électrode (E2) l'une à l'autre et isolant électriquement la première (E1) et la deuxième électrode (E2) l'une de l'autre,
et une portion élastiquement flexible où sont présentes la première électrode (E1), la deuxième électrode (E2) et la couche diélectrique (C1), **caractérisé en ce que** le composant électromécanique a une capacité fonction d'une épaisseur (e) constante ou non de la couche diélectrique (C1),
et **en ce que**, au niveau de la portion élastiquement flexible, la couche diélectrique (C1) comporte plusieurs tronçons particuliers (3) ayant chacun une orientation et une position telles que, lorsque la portion élastiquement flexible est cintrée élastiquement, l'épaisseur (e) de la couche diélectrique (C1) est modifiée au moins au niveau de ces tronçons particuliers (3) de manière que la capacité du composant électromécanique soit changée.

2. Composant selon la revendication 1, **caractérisé en ce que** la portion élastiquement flexible est une portion qui est élastiquement flexible dans un plan de flexion (P) et dont la section selon ce plan de flexion (P) est une section allongée, la couche diélectrique (C1) s'étendant selon une surface qui est cannelée sur au moins une partie de la longueur de la section allongée de la portion élastiquement flexible.

3. Composant selon la revendication 2, **caractérisé en ce que** la portion flexible est à même d'être cintrée dans le plan de flexion (P) moyennant la présence de deux types de sollicitation, à savoir une compression et une traction dont chacune se produit dans l'une de deux régions distinctes de la portion élastiquement flexible, la surface cannelée selon laquelle s'étend la couche diélectrique (C1) ou la portion cannelée de la surface selon laquelle s'étend la couche diélectrique (C1) se trouvant plus dans l'une des deux régions distinctes que dans l'autre, par exemple entièrement dans l'une de ces deux régions distinctes.

4. Composant selon l'une quelconque des revendications précédentes, **caractérisé en ce que** la portion élastiquement flexible est une portion qui est élastiquement flexible dans un plan de flexion (P), la couche diélectrique (C1) s'étendant selon une ligne directrice (d) et parallèlement à une génératrice ( 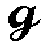 ) qui est sensiblement perpendiculaire au plan de flexion (P).

5. Composant selon l'une quelconque des revendications précédentes, **caractérisé en ce que** la première électrode (E1) est réalisée en un premier matériau qui est du silicium monocristallin (A), la couche diélectrique (C1) étant réalisée en un deuxième matériau (B), la deuxième électrode (E2) étant réalisée en un troisième matériau (C) différent des premier et deuxième matériaux.

6. Composant selon l'une quelconque des revendications précédentes, **caractérisé en ce que** la première électrode (E1) est réalisée en silicium monocristallin (A), la couche diélectrique (C1) étant réalisée en oxyde de silicium (B).

7. Composant selon la revendication 6, **caractérisé en ce que** la deuxième électrode (E2) est réalisée en silicium polycristallin (C).

8. Composant selon l'une quelconque des revendications précédentes, **caractérisé en ce que** chacun des tronçons particuliers (3) a une orientation et une position telles que, lorsque la première (E1) et la deuxième électrode (E2) sont mises à des potentiels différents et produisent entre eux une compression de la couche diélectrique (C1), la compression des tronçons particuliers (3) amène la portion élastiquement flexible à se cintrer.

9. Composant selon l'une quelconque des revendications précédentes, **caractérisé en ce qu'**il comprend une borne (5) de connexion à la première électrode (E1), une borne (6) de connexion à la deuxième électrode (E2), ainsi qu'une masse d'inertie (931 ; 1031 ; 1131) accouplée à la portion élastiquement flexible de manière à pouvoir cintrer élastiquement cette portion élastiquement flexible.

10. Composant selon l'une quelconque des revendications précédentes, **caractérisé en ce que** la première électrode (E1), la deuxième électrode (E2), la couche diélectrique (C1) et la portion élastiquement flexible appartiennent à une première sous-partie (932 ; 1032 ; 1132) du composant électromécanique, ce composant électromécanique comprenant au moins une deuxième sous-partie (932 ; 1032 ; 1132), cette deuxième sous-partie (932 ; 1032 ; 1132) incluant les mêmes caractéristiques qu'un composant électromécanique selon l'une quelconque des revendications précédentes, la portion élastiquement flexible (932 ; 1032 ; 1132) de la première sous-partie et la portion élastiquement flexible (932 ; 1032 ; 1132) de la deuxième sous-partie étant élastiquement flexibles dans un plan de flexion commun et/ou dans deux plans de flexion parallèles et étant accouplées l'une à l'autre au moyen d'un accouplement (931 ; 1031 ; 1131) favorisant une synchronisation de leurs déformations élastiques respectives dans le plan de flexion commun et/ou de leurs déformations élastiques respectives dans les deux plans de flexion parallèles.

11. Composant selon l'une quelconque des revendications précédentes, **caractérisé en ce que** ladite capacité est une première capacité, le composant électromécanique comportant une structure à plans parallèles qui comprend deux électrodes, à savoir une troisième et une quatrième électrode, le composant électromécanique ayant une deuxième capacité entre ces troisième et quatrième électrodes, une extrémité de la portion élastiquement flexible portant la troisième électrode.

12. Procédé de fabrication d'un composant (101 ; 201 ; 301 ; 401 ; 501 ; 601 ; 701 ; 801 ; 901 ; 1001 ; 1101) selon l'une quelconque des revendications précédentes, comprenant des étapes dans lesquelles :
a) on creuse au moins un trou (13) dans une plaquette (10) faite de silicium,
b) on crée la couche diélectrique (C1) au moins au niveau d'une paroi du trou (13),
c) on remplit le trou (13) avec le matériau (C) de la deuxième électrode (E2),
d) dans la plaquette (10, 13, C1, C) telle qu'elle a été modifiée par les étapes a) à c), on découpe le composant électromécanique (101 ; 201 ; 301 ; 401 ; 501 ; 601 ; 701 ; 801 ; 901 ; 1001 ; 1101).

13. Procédé de fabrication selon la revendication 12, dans l'étape b) duquel on crée la couche diélectrique (C1) en oxyde de silicium (B).

14. Procédé de fabrication selon la revendication 12, dans l'étape b) duquel on crée la couche diélectrique (C1) en oxyde de silicium (B) par oxydation thermique.

15. Procédé de fabrication selon l'une quelconque des revendications 12 à 14, dans l'étape c) duquel le matériau avec lequel on remplit le trou est du silicium polycristallin (C).

16. Procédé de fabrication selon la revendication 15 et l'une quelconque des revendications 13 et 14, comportant une étape qui a lieu après l'étape c) et dans laquelle on soumet la plaquette (10, 13, C1, C) ou le composant électromécanique (101 ; 201 ; 301 ; 401 ; 501 ; 601 ; 701 ; 801 ; 901 ; 1001 ; 1101) à des conditions qui sont identiques à des conditions utilisées pour effectuer une oxydation thermique de silicium.

17. Procédé de fabrication selon l'une quelconque des revendications 12 à 16, dans lequel, au moins lors des étapes a) à c), la plaquette (10) fait partie d'un wafer (11) dans lequel la plaquette (10) comprend une première face principale unie à un support (15) et une deuxième face principale opposée à la première face principale, le procédé de fabrication comprenant une étape qui a lieu après l'étape c) et dans laquelle on polit la deuxième face principale de la plaquette (10, 13, C1, C).

18. Procédé de fabrication selon l'une quelconque des revendications 12 à 17, dans lequel on réalise au moins l'une des étapes a) et d) par gravure.

## Patentansprüche

1. Elektromechanische Komponente, umfassend mindestens eine erste Elektrode (E1) und eine zweite Elektrode (E2),
eine dielektrische Schicht (C1), welche die erste (E1) und die zweite Elektrode (E2) miteinander mechanisch verbindet und die erste (E1) und die zweite Elektrode (E2) elektrisch voneinander isoliert,
und einen elastisch flexiblen Bereich, in dem die erste Elektrode (E1), die zweite Elektrode (E2) und die dielektrische Schicht (C1) vorhanden sind, **dadurch gekennzeichnet, dass** die elektromechanische Komponente eine Kapazität als eine Funktion einer Dicke (e), konstant oder nicht, der dielektrischen Schicht (C1) aufweist,
und dadurch, dass in dem elastisch flexiblen Bereich die dielektrische Schicht (C1) eine Vielzahl von spezifischen Segmenten (3) umfasst, welche jeweils eine Orientierung und eine Position haben, dass wenn der elastisch flexible Bereich elastisch gebogen ist, die Dicke (e) der dielektrischen Schicht (C1) zumindest in den spezifischen Segmenten (3) derart modifiziert ist, dass die Kapazität der elektromagnetischen Komponenten verändert ist.

2. Komponente nach Anspruch 1, **dadurch gekennzeichnet, dass** der elastisch flexible Bereich ein Bereich ist, welcher elastisch flexibel in einer Biegeebene (P) ist und dessen Abschnitt entsprechend der Biegeebene (P) ein langgestreckter Abschnitt ist, wobei die dielektrische Schicht (C1) sich entlang einer Fläche erstreckt, welche zumindest in einem Teil der Länge des langgestreckten Abschnitts des elastisch flexiblen Bereichs geriffelt ist.

3. Komponente nach Anspruch 2, **dadurch gekennzeichnet, dass** der flexible Bereich in der Biegeebene (P) gebogen werden kann, um zwei Typen an Spannung hervorzurufen, d.h. einen Druck und einen Zug, wobei jede in einer von zwei getrennten Regionen des elastisch flexiblen Bereichs auftritt, der geriffelten Fläche, entlang welche sich die dielektrische Schicht (C1) erstreckt oder dem geriffelten Abschnitt der Fläche, entlang welche sich die dielektrische Schicht (C1) erstreckt, welche mehr in einem der zwei getrennten Regionen lokalisiert ist als in der anderen, beispielsweise vollständig in einer der zwei getrennten Regionen.

4. Komponente nach einem der vorhergehenden Ansprüche, **dadurch gekennzeichnet, dass** der elastisch flexible Bereich ein Bereich ist, welcher elastisch flexibel in einer Biegeebene (P) ist, wobei die dielektrische Schicht (C1) sich entlang einer Leitlinie (d) und parallel zu einer Mantellinie ( 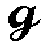 ) erstreckt, welche im Wesentlichen senkrecht zu der Biegeebene (P) ist.

5. Komponente nach einem der vorhergehenden Ansprüche, **dadurch gekennzeichnet, dass** die erste Elektrode (E1) aus einem ersten Material gefertigt ist, welches aus monokristallinem Silizium (A) ist, die dielektrische Schicht (C1) aus einem zweiten Material (B) gefertigt ist, die zweite Elektrode (E2) aus einem dritten Material (C) gefertigt ist, welches zu den ersten und zweiten Materialien unterschiedlich ist.

6. Komponente nach einem der vorhergehenden Ansprüche, **dadurch gekennzeichnet, dass** die erste Elektrode (E1) aus monokristallinem Silizium (A) ist und die dielektrische Schicht (C1) aus Siliziumoxid (B) gefertigt ist.

7. Komponente nach Anspruch 6, **dadurch gekennzeichnet, dass** die zweite Elektrode (E2) aus polykristallinem Silizium (C) ist.

8. Komponente nach einem der vorhergehenden Ansprüche, **dadurch gekennzeichnet, dass** die spezifischen Abschnitte (3) eine Orientierung und eine Position haben, dass wenn die erste (E1) und die zweite Elektrode (E2) auf verschiedene Potentiale gesetzt sind und zwischen sich ein Druck auf die dielektrische Schicht (C1) erzeugen, der Druck der spezifischen Abschnitte (3) den elastisch flexiblen Bereich zum Biegen veranlasst.

9. Komponente nach einem der vorhergehenden Ansprüche, **dadurch gekennzeichnet, dass** sie eine Anschlussklemme (5) zu der ersten Elektrode (E1), einen Anschlussklemme (6) zu der zweiten Elektrode (E2) sowie ein Gewicht (931; 1031; 1131) umfasst, welches mit dem elastisch flexiblen Bereich derart gekoppelt ist, dass der elastisch flexible Bereich biegbar ist.

10. Komponente nach einem der vorhergehenden Ansprüche, **dadurch gekennzeichnet, dass** die erste Elektrode (E1), die zweite Elektrode (E2), die dielektrische Schicht (C1) und der elastisch flexible Bereich zu einem ersten Unterabschnitt (932; 1032; 1132) der elektromechanischen Komponente gehören, die elektromechanische Komponente umfasst mindestens einen zweiten Unterabschnitt (932; 1032; 1132), wobei der zweite Unterabschnitt (932; 1032; 1132) die gleichen Merkmale umfasst wie die elektromechanische Komponente nach einem der vorhergehenden Ansprüche, wobei der elastisch flexible Bereich (932; 1032; 1132) des ersten Unterabschnitts und der elastisch flexible Bereich (932; 1032; 1132) des zweiten Unterabschnitts in einer gemeinsamen Biegeebene und/oder in zwei parallelen Biegeebenen elastisch flexibel sind und miteinander mittels einer Verbindung (931; 1031; 1131) verbunden sind, welche eine Synchronisierung der jeweiligen elastischen Deformationen in der gemeinsamen Biegeebene und/oder in den zwei parallelen Biegeebenen begünstigt.

11. Komponente nach einem der vorhergehenden Ansprüche, **dadurch gekennzeichnet, dass** die Kapazität eine erste Kapazität ist, wobei die elektromechanische Komponente eine Struktur paralleler Ebenen umfasst, die zwei Elektroden umfasst, d.h. eine dritte und eine vierte Elektrode, wobei die elektromechanische Komponente eine zweite Kapazität zwischen den dritten und vierten Elektroden aufweist, wobei ein Ende des elastisch flexiblen Bereichs die dritte Elektrode lagert.

12. Verfahren zur Herstellung einer Komponente (101; 201; 301; 401; 501; 601; 701; 801; 901; 1001; 1101) nach einem der vorhergehenden Ansprüche, umfassend Schritte zum:
a) Fertigen zumindest einer Öffnung (13) in einer Platte (10), gefertigt aus Silizium,
b) Erzeugen der dielektrischen Schicht (C1) zumindest an einer Wand der Öffnung (13),
c) Füllen der Öffnung (13) mit dem Material (C) der zweiten Elektrode (E2),
d) Schneiden der elektromechanischen Komponente (101; 201; 301; 401; 501; 601; 701; 801; 901; 1001; 1101) in der Platte (10, 13, C1, C), welche gemäss den Schritten a) bis c) modifiziert ist.

13. Herstellungsverfahren nach Anspruch 12, wobei in Schritt b) die dielektrische Schicht (C1) aus Siliziumoxid (B) hergestellt ist.

14. Herstellungsverfahren nach Anspruch 12, wobei in Schritt b) die dielektrische Schicht (C1) aus Siliziumoxid durch thermische Oxidation hergestellt ist.

15. Herstellungsverfahren nach einem der Ansprüche 12 bis 14, wobei in Schritt c) das Material, mit dem die Öffnung gefüllt ist, polykristallines Silizium (C) ist.

16. Herstellungsverfahren nach Anspruch 15 und einem der Ansprüche 13 und 14, umfassend einen Schritt, welcher nach Schritt c) erfolgt und in welchem die Platte (10, 13, C1, C) oder die elektromechanische Komponente (101; 201; 301; 401; 501; 601; 701; 801; 901; 1001; 1101) Bedingungen unterworfen wird, welche identisch zu den Bedingungen zum Vorformen einer thermischen Oxidation von Silizium sind.

17. Herstellungsverfahren nach einem der vorhergehenden Ansprüche 12 bis 16, wobei zumindest während der Schritte a) bis c) die Platte (10) Teil eines Wafers (11) bildet, wobei die Platte (10) eine erste Hauptseite umfasst, vereint mit einem Träger (10) und eine zweite Hauptseite, welche der ersten Hauptseite gegenüberliegt, wobei das Herstellungsverfahren einen Schritt umfasst, welcher nach Schritt c) erfolgt und in dem die zweite Hauptseite der Platte (10, 13, C1, C) poliert wird.

18. Herstellungsverfahren nach einem der Ansprüche 12 bis 17, wobei zumindest eine der Schritte a) und d) durch Ätzen erreicht wird.

## Claims

1. Electromechanical component, comprising at least one first electrode (E1) and a second electrode (E2),
a dielectric layer (C1) mechanically connecting the first (E1) and the second electrode (E2) to one another and electrically insulating the first (E1) and second electrode (E2) from one another,
and an elastically flexible portion where the first electrode (E1), the second electrode (E2) and the dielectric layer (C1) are present, **characterized in that** the electromechanical component has a capacity as a function of a thickness (e), constant or not, of the dielectric layer (C1),
and **in that**, at the elastically flexible portion, the dielectric layer (C1) comprises a plurality of specific segments (3) each having an orientation and a position such that, when the elastically flexible portion is elastically bent, the thickness (e) of the dielectric layer (C1) is modified at least at these specific segments (3) in such a way that the capacity of the electromagnetic component is changed.

2. Component according to claim 1, **characterized in that** the elastically flexible portion is a portion which is elastically flexible in a bending plane (P) and whose section according to this bending plane (P) is an elongated section, the dielectric layer (C1) extending along a surface which is fluted on at least one part of the length of the elongated section of the elastically flexible portion.

3. Component according to claim 2, **characterized in that** the flexible portion is able to be bent in the bending plane (P) bringing about the presence of two types of stress, i.e. a compression and a tension, each of which occurs in one of the two distinct regions of the elastically flexible portion, the fluted surface along which the dielectric layer (C1) extends or the fluted portion of the surface along which the dielectric layer (C1) extends being located more in one of the two distinct regions than in the other, for example entirely in one of these two distinct regions.

4. Component according to any one of the preceding claims, **characterized in that** the elastically flexible portion is a portion which is elastically flexible in a bending plane (P), the dielectric layer (C1) extending along a directrix line (d) and parallel to a generatrix ( 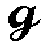 ) which is substantially perpendicular to the bending plane (P).

5. Component according to any one of the preceding claims, **characterized in that** the first electrode (E1) is made of a first material which is of monocrystalline silicon (A), the dielectric layer (C1) being made of a second material (B), the second electrode (E2) being made of a third material (C) different from the first and second materials.

6. Component according to any one of the preceding claims, **characterized in that** the first electrode (E1) is made of monocrystalline silicon (A), the dielectric layer (C1) being made of silicon oxide (B).

7. Component according to claim 6, **characterized in that** the second electrode (E2) is made of polycrystalline silicon (C).

8. Component according to any one of the preceding claims, **characterized in that** each of the specific segments (3) has an orientation and a position such that, when the first (E1) and the second electrode (E2) are set at different potentials and produce between them a compression of the dielectric layer (C1), the compression of the specific segments (3) causes the elastically flexible portion to bend.

9. Component according to any one of the preceding claims, **characterized in that** it comprises a connection terminal (5) to the first electrode (E1), a connection terminal (6) to the second electrode (E2), as well as a weight (931 ; 1031 ; 1131) coupled to the elastically flexible portion in such a way as to enable this elastically flexible portion to bend.

10. Component according to any one of the preceding claims, **characterized in that** the first electrode (E1), the second electrode (E2), the dielectric layer (C1) and the elastically flexible portion belong to a first sub-part (932 ; 1032 ; 1132) of the electromechanical component, this electromechanical component comprising at least a second sub-part (932 ; 1032 ; 1132), this second sub-part (932 ; 1032 ; 1132) including the same features as an electromechanical component according to any one of the preceding claims, the elastically flexible portion (932 ; 1032 ; 1132) of the first sub-part and the elastically flexible portion (932 ; 1032 ; 1132) of the second sub-part being elastically flexible in a common bending plane and/or in two parallel bending planes and being coupled to one another by means of a coupling (931 ; 1031 ; 1131) favoring a synchronization of their respective elastic deformations in the common bending plane and/or of their respective elastic deformations in the two parallel bending planes.

11. Component according to any one of the preceding claims, **characterized in that** the said capacity is a first capacity, the electromechanical component comprising a structure of parallel planes which comprises two electrodes, i.e. a third and a fourth electrode, the electromechanical component having a second capacity between these third and fourth electrodes, one end of the elastically flexible portion bearing the third electrode.

12. Method of production of a component (101 ; 201 ; 301 ; 401 ; 501 ; 601 ; 701 ; 801 ; 901 ; 1001 ; 1101) according to any one of the preceding claims, comprising steps in which :
a) at least one hole (13) is made in a plate (10) made of silicon,
b) the dielectric layer (C1) is created at least at a wall of the hole (13),
c) the hole (13) is filled with the material (C) of the second electrode (E2),
d) the electromechanical component (101 ; 201 ; 301 ; 401 ; 501 ; 601 ; 701 ; 801 ; 901 ; 1001 ; 1101) is cut in the plate (10, 13, C1, C) as modified by the steps a) to c).

13. Production method according to claim 12, in step b) of which the dielectric layer (C1) is created of silicon oxide (B).

14. Production method according to claim 12, in step b) of which the dielectric layer (C1) is created of silicon oxide (B) by thermal oxidation.

15. Production method according to any one of the claims 12 to 14, in step c) of which the material with which the hole is filled is polycrystalline silicon (C).

16. Production method according to claim 15 and any one of the claims 13 and 14, comprising a step which is taken after step c) and in which the plate (10, 13, C1, C) or the electromechanical component (101 ; 201 ; 301 ; 401 ; 501 ; 601 ; 701 ; 801 ; 901 ; 1001 ; 1101) is subjected to conditions which are identical to the conditions used to perform a thermal oxidation of silicon.

17. Production method according to any one of the claims 12 to 16, wherein, at least during steps a) to c), the plate (10) forms part of a wafer (11) in which the plate (10) comprises a first main face united to a support (15) and a second main face opposite the first main face, the production method comprising a step which is taken after step c) and in which the second main face of the plate (10, 13, C1, C) is polished.

18. Production method according to any one of the claims 12 to 17, wherein at least one of the steps a) and d) is achieved by etching.
